Europäisches Patentamt

European Patent Office

Office européen des brevets

(11) Publication number: **0 164 685 B1**

## EUROPEAN PATENT SPECIFICATION

(45) Date of publication of patent specification: **11.11.92**

(51) Int. Cl.5: **H03J 3/16**, H01P 1/215

(21) Application number: **85106913.8**

(22) Date of filing: **04.06.85**

(54) Signal converter.

(30) Priority: **05.06.84 JP 114794/84**

(43) Date of publication of application:
**18.12.85 Bulletin 85/51**

(45) Publication of the grant of the patent:
**11.11.92 Bulletin 92/46**

(84) Designated Contracting States:
**DE FR GB NL**

(56) References cited:
FR-A- 2 537 346
US-A- 3 839 677
US-A- 3 939 429
US-A- 4 152 676
US-A- 4 188 594

ELECTRONICS INTERN., vol. 51, no. 9, 27th
April 1978, pages 70,72; "Flat, simple-
to-handle YIG resonator is a snap to orient
in an oscillator"

MARCONI INSTRUMENTATION, vol. 15, no. 4,
1972, pages 76-79, Saint Albans, Herts, GB;
G.J. HURST: "YIG and what it means to mi-
crowave instruments"

1985 IEEE-MTT-S INTERNATIONAL MICRO-

WAVE SYMPOSIUM DIGEST, St. Louis, Mis-
souri, 4th-6th June 1985, pages 285-288,
IEEE; Y. MURAKAMI et al.: "A bandpass filter
using YIG film grown by LPE"

(73) Proprietor: **SONY CORPORATION**
**7-35 Kitashinagawa 6-chome Shinagawa-ku**
**Tokyo 141(JP)**

(72) Inventor: **Murakami, Yoshikazu**
**Sony Corporation 7-35 Kitashinagawa**
**6-chome**
**Shinagawa-ku Tokyo(JP)**
Inventor: **Ito, Seigo**
**Sony Corporation 7-35 Kitashinagawa**
**6-chome**
**Shinagawa-ku Tokyo(JP)**
Inventor: **Yamada, Toshiro**
**Sony Corporation 7-35 Kitashinagawa**
**6-chome**
**Shinagawa-ku Tokyo(JP)**

(74) Representative: **TER MEER - MÜLLER - STEIN-**
**MEISTER & PARTNER**
**Mauerkircherstrasse 45**
**W-8000 München 80(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

**Description**

The present invention relates to a signal converter used in a tuning device for a radio receiver, a television receiver and the like. An article of G.J. Hurst with the title "YIG and what it means to microwave instruments" published in Marconi Instrumentation, Vol. 15, No. 4, p. 76-79 describes a signal converter having the following features:

- a filter (2; 205) formed of a first ferromagnetic resonator comprising a first ferrimagnetic crystal biased with a first D.C. bias magnetic field perpendicular to a major surface of said crystal supplied by a first D.C. bias magnetic filed means, said filter being supplied with an input signal to be converted, and deriving a filter signal having a first frequency;
- a local oscillator (5; 207) formed of an active element and a second ferromagnetic resonator comprising a second ferrimagnetic crystal biased with a second D.C. bias magnetic field perpendicular to a major surface of said crystal supplied by a second D.C. bias magnetic field means, for deriving an oscillating signal having a second frequency; and
- a mixer (4 - 206) for mixing said filter signal and said oscillating signal and for deriving a converted signal;

An article published in Electronics International, Vol. 51, No. 9 (1978.04), p. 70 and 72 with the title "Flat, simple-to-handle YIG resonator is a snap to orient in an oscillator" describes a YIG resonater having a thin film ferrimagnetic crystal magnetically coupled with microstrip lines. This article describes that one of a plurality of essential problems arising when using thin film ferrimagnetic crystals is caused by spurious modes.

It is an object of the present invention to provide a signal converter using the ferromagnetic resonance effect, said converter having a simple construction and essentially not suffering from the effects of spurious modes.

The signal converter of the present invention comprises the above listed features of the prior art converter and is characterized in that

- said ferrimagnetic crystals are thin film crystals, wherein at least one of said thin films is processed to have different thicknesses in the central and peripheral regions to thereby suppress spurious response of ferromagnetic resonance caused by magnetostatic modes other than the uniform mode, and each of these crystals is magnetically coupled by a microstrip line.

According to an advantageous embodiment, the signal converter does not comprise only a filter and a local oscillator, but it additionally comprises a second local oscillator and a second mixer in the input stage of the filter. Therefore, the filter does not receive the original input signal but it receives a signal mixed of said input signal and the signal from the second local oscillator. Such an arrangement is principally described in US-A-3,939,429 which, however, does not use thin film ferrimagnetic crystals.

US-A-4,152,676 describes an electromagnetic signal processor for e. g. filtering and/or delaying electromagnetic waves. The signal processor uses a bulk single crystal sample in which a non-uniform field is generated to provide confinement and guiding of wave modes. Preferably, mechanical deformation is employed to generate the required field profiles to provide a track or tracks for the waves. In an embodiment, a circular groove of rectangular cross dimension is cut into the magnetic crystal as a mechanical deformation. Waves propagate along the groove from an input electrode, traversing the groove, to an output electrode, traversing the groove at another location separated from the location of the input electrode. Thus, the signal processor as disclosed in US-A-4,152,676 has so to speak opposite function than the signal converter of the present invention, as in the prior art signal processor, a groove is established in the bulk crystal in a way to guide waves, whereas in the signal converter of the present invention, a groove is provided in a thin film crystal in a way to block waves.

Fig. 1 is a block diagram of a receiver as an embodiment of the invention;
Fig. 2 is a plan view of YIG filter;
Fig. 3 is a sectional view taken in line A-A of Fig. 2;
Fig. 4 is a plan view of a local oscillator;
Fig. 5 is a sectional view taken in line A-A of Fig. 4;
Fig. 6a and 6b is a block diagram of an oscillator;
Fig. 7 is a diagram of circuit constitution of the oscillator;
Fig. 8 is Smith chart illustrating oscillation action;
Fig. 9 is a plan view of a receiver as an example;
Fig. 10 is a sectional view taken in line A-A of Fig. 9;
Fig. 11 through Fig. 13 are sectional views of magnetic field applying means;
Fig. 14 is a graph illustrating magnetostatic mode generated in a circular ferrimagnetic thin film;

2

EP 0 164 685 B1

Fig. 15 is a graph illustrating distribution of internal d.c. magnetic field of the circular ferrimagnetic thin film;

Fig. 16 is a graph illustrating relation between distribution of the internal d.c. magnetic field and the magnetostatic mode in the circular ferrimagnetic thin film;

Fig. 17 is a perspective view of a magnetic resonance element;

Fig. 18 is a sectional view of the magnetic resonance element;

Fig. 19 is a graph illustrating insertion loss in the magnetic resonance element;

Fig. 20 is a graph illustrating insertion loss in a comparison example;

Figs. 21 and 22 are graphs illustrating distribution of demagnetizing field in the circular ferrimagnetic thin film;

Fig. 23 is a perspective view of a magnetic resonance element;

Fig. 24 is a graph illustrating insertion loss of the magnetic resonance element;

Fig. 25 is a diagram illustrating schematic constitution of a magnetic circuit;

Fig. 26, Fig. 27 and Fig. 30 are diagrams illustrating schematic constitution of magnetic circuits to be applied to the invention;

Fig. 28 and Fig. 29 are diagrams illustrating relation between the magnetic adjuster and temperature variation of the resonance frequency;

Fig. 31 and Fig. 32 are diagrams illustrating characteristics of a magnetic circuit; and

Fig. 33 and Fig. 34 are block diagrams of receivers as other embodiments of the invention.

DESCRIPTION OF THE PREFERRED EMBODIMENTS

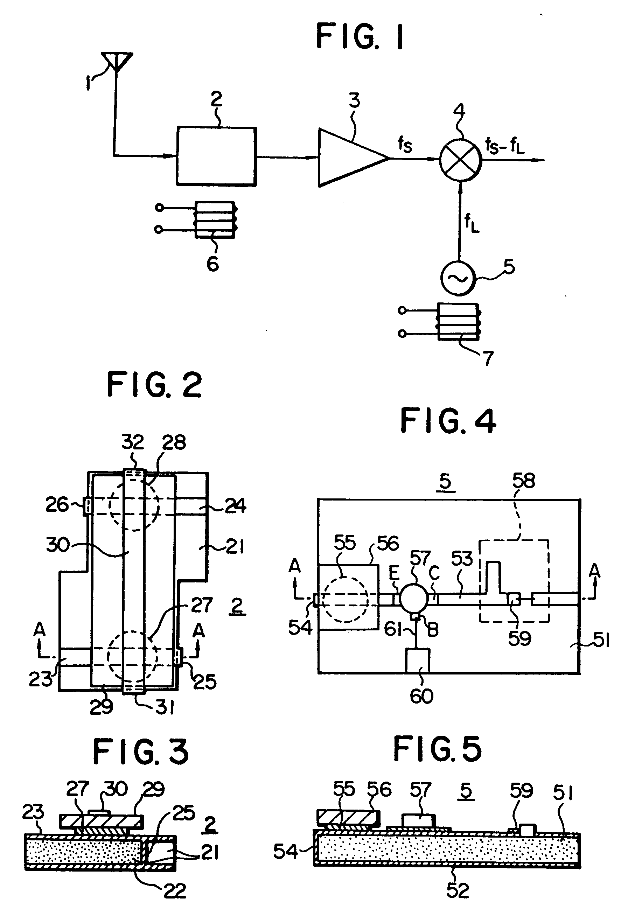

A signal converter as an embodiment of the invention will now be described referring to Fig. 1. The embodiment is of superhetorodyne type, and comprises an antenna 1, a high-frequency filter circuit 2 using ferromagnetic resonator such as YIG resonator, a high-frequency amplifier 3, a mixer 4, a local oscillator 5 including a resonator using ferromagnetic resonator such as YIG resonator, and magnetic field applying means 6 and 7 which supply magnetic fields variably to YIG resonator elements in the filter circuit 2 and the local oscillator 5 respectively. Both means 6 and 7 may be adjusted in interlocking. Resonance frequency of the YIG element in the filter circuit 2 is adjusted by the means 6, thereby selection of pass band center frequency in the filter circuit 2, that is, selection of tuning frequency or tuning action is effected. In this case, signal received from the antenna 1 is introduced to the YIG filter circuit 2, and signal of frequency $f_S$ passingthrough the filter circuit 2 is amplified by the high-frequency amplifier 3 and then introduced to the mixer 4 and mixed with local oscillation signal of frequency $f_L$ from the local oscillator 5, and signal of intermediate frequency $f_S$-$f_L$ is taken out from the mixer 4.

In the invention, special constitution is adopted in the YIG filter circuit 2 and the YIG resonator of the local oscillator 5.

The magnetic resonance element is formed on a common paramagnetic substrate such as GGG (gadolinium•gallium•garnet) substrate by means of thin film forming method, such as sputtering, chemical vapor deposition (CVD) or liquid phase epitaxy (LPE), into a ferrimagnetic thin film, e.g. YIG thin film. The YIG thin film is patterned by photolithography thereby both YIG thin film magnetic resonance elements are simultaneously formed on the common GGG substrate. In this case YIG thin film elements to constitute the YIG filter circuit 2 and the YIG resonator of the local oscillator 5 respectively have the same shape, such as disk, square or rectangular shape. Difference of resonance frequencies, that is, offset frequency can be set by selecting aspect ratio of each YIG thin film element, for example, ratio of film thickness to diameter in the case of disk shape. If both YIG thin film elements are formed by the same film, in the case of disk shape, offset frequency is set by selecting different diameters of both elements. For example, if saturated magnetization $4\pi M_s$ of YIG is $4\pi M_s = 1780$ Gauss and the film thickness t is 20 $\mu$m and diameters are selected to 4mm and 2mm respectively, aspect ratio becomes 0.005 and 0.01 and the offset frequency becomes 56MHz. Both elements are disposed in the same magnetic field. For example, both magnetic field generating means 6 and 7 in Fig. 1 may be formed commonly. Or both elements may be selected to the same shape and size hence the same aspect ratio and one element may be supplied with magnetic field being different from that of other element by a definite amount so as to set a required offset frequency.

Both resonance elements of YIG thin film are provided by the same thin film element in the above embodiment. When the YIG thin film is formed on the substrate by means of thin film forming method such as CVD, LPE or sputtering, the film thickness can be obtained uniformly and precisely. Consequently, even when both YIG thin film resonance elements are formed on separate substrates by the same or different process, the resonance frequency can be set accurately without dispersion in comparison to the case where YIG monocrystalline substance such as YIG sphere or YIG monocrystalline plate is machined by cutting or polishing so as to obtain YIG magnetic resonance element.

An example of independent constitution of a filter circuit 2 and a local oscillator 5 will be described. Fig. 2 shows a plan view of an example of structure of the filter circuit 2, and Fig. 3 shows a sectional view thereof. In this example, a first major surface of a dielectric substrate 21 of alumina or the like has a ground conductor 22 adhered thereon, and a second major surface has first and second micro strip lines in parallel to each other, i.e. input and output transmission lines 23 and 24 adhered thereon. Ends of both strip lines 23 and 24 are connected to the ground conductor 22 through first and second connecting conductors 25 and 26 respectively. First and second YIG thin film magnetic resonance elements 27 and 28 are disposed on the second major surface of the substrate 21 in electromagnetic coupling with the first and second micro strip lines 23 and 24 respectively. The first and second magnetic resonance elements 27 and 28 are constituted in a process that YIG thin film is formed on a major surface of GGG substrate 29 by the thin film forming method and then patterned in disk shape by using photolithography technique including selective etching. A third micro strip line, i.e. coupling transmission line 30 is formed between the first and second magnetic resonance elements 27 and 28 on the substrate 29 so as to couple these element electromagnetically and adhered to other surface of the substrate 29. Both ends of the third strip line 30 are connected to the ground conductor 22 through connecting conductors 31 and 32 respectively. Distance between both elements 27 and 28 is selected to $\lambda/4$ wherein $\lambda$ is wave length of the center frequency in the pass band so that insertion loss in the cutoff region outside the pass band is sharply increased.

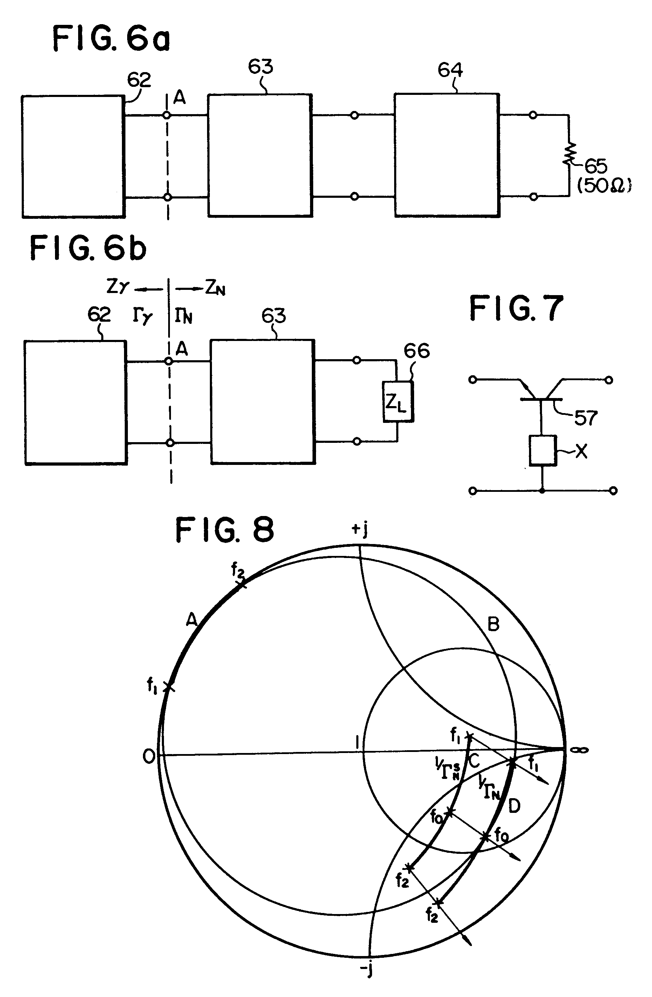

On the other hand, Fig. 4 shows an example of structure of the local oscillator 5, and Fig. 5 shows a sectional view taken on line A-A of Fig. 4. A first major surface of a dielectric substrate 51 of alumina or the like has a ground conductor 52 adhered thereon, and a second major surface has a micro strip line 53 adhered thereon. One end of the micro strip line 53 is connected to the ground conductor 52 through a connecting conductor 54. YIG thin film magnetic resonance element 55 is electromagnetically coupled to the micro strip line 53. The YIG thin film magnetic resonance element 55 is in a process that YIG thin film is formed on a major surface of GGG substrate 56 by the thin film forming method and then patterned in disk shape by photolithography. Numeral 57 designates a high-frequency bipolar transistor, numeral 58 an impedance converter, and numeral 59 a MOS capacitor for blocking D.C. component. In this example, base B of the transistor 57 is connected through a wire 61 to a ground pad 60 in turn connected to the ground conductor 52, emitter E is connected to side of the element 55, and collector C is connected to side of the impedance converter 58, thereby series feedback type oscillator utilizing common base transister is constituted.

Next, oscillation principle and condition for the oscillation will be described in connection with the circuit using the magnetic resonance element as a resonator. The resonator, i.e. YIG magnetic resonance element 55 is inserted to feedback circuit other than output circuit. Fig. 6a and Fig. 6b are block diagrams of the oscillating circuit. Numeral 62 designates YIG resonance circuit, numeral 63 a negative resistance circuit, numeral 64 an impedance matching circuit, and numeral 65 a load. Numeral 66 in Fig. 6-b designates a load impedance including the impedance matching circuit.

In Fig. 6, reflection coefficient $\Gamma_Y$ at a side of YIG resonance circuit viewing from terminal A, i.e. side of YIG feedback circuit, and reflection coefficient $\Gamma_N$ at a side of active element, i.e. side of negative resistance circuit, are expressed by following formulae using respective impedances $Z_Y$ and $Z_N$ viewing from the terminal A.

$$\Gamma_Y = \frac{Z_Y - Z_O}{Z_Y + Z_O} \qquad (1)$$

$$\Gamma_N = \frac{Z_N - Z_O}{Z_N + Z_O} \qquad (2)$$

wherein $Z_O$: characteristic impedance (50Ω).

Condition of steady oscillation is expressed by following formula using $\Gamma_Y$ and $\Gamma_N$.

$$\Gamma_Y \Gamma_N = 1 \qquad (3)$$

Since both $\Gamma_Y$ and $\Gamma_N$ are complex numbers, formula (3) by separating in amplitude and phase

becomes as follows:

$$|\Gamma_Y| \; |\Gamma_N| \; e^{j(\theta_Y + \theta_N)} = 1$$

hence

$$|\Gamma_Y||\Gamma_N| = 1 \qquad (4)$$

$$\theta_Y + \theta_N = 0 \qquad (5)$$

Since the YIG feedback circuit being passive element circuit has positive real resistance of loss component of the YIG resonator, it follows from formula (1) that $|\Gamma_Y| < 1$. Consequently, in order to satisfy the oscillation condition of formula (4), condition $|\Gamma_Y| >$ is required and it follows from formula (2) that $Z_n$ must have negative real resistance.

The negative feedback circuit in Fig. 6 may be a two-terminal active element of negative resistance or a circuit composed of three-terminal active element and feedback element. The example described in Fig. 4 and Fig. 5 uses high-frequency bipolar transistor. Fig. 7 shows constitution of a series feedback type oscillating circuit utilizing common base transistor, and X designates a reactive circuit.

Above description of the oscillating circuit relates to steady oscillation. In order that the oscillation rises, however, following condition must be satisfied.

$$|\Gamma_Y||\Gamma_N^S| > 1 \qquad (6)$$

hence

$$|\Gamma_Y| > \frac{1}{|\Gamma_N^S|} \qquad (7)$$

Wherein $\Gamma_N^S$ is value of $\Gamma_N$ at small signal. If the oscillation rises and the active element performs large amplitude operation, absolute value of the negative resistance decreases and value $1/|\Gamma_N|$ gradually increases and the oscillation becomes steady when formula (2) is satisfied.

Based on above conditions, operation principle of the YIG oscillating circuit will be described referring to Smith chart in Fig. 8. At small signal state, value $1/\Gamma_N$ is at C state in relatively inner side of the Smith chart. However, as the active element performs large amplitude operation, $1/\Gamma_N$ passes through D state and is transferred in arrow direction.

In constitution of Fig. 4 and Fig. 5, if the YIG element 55 is not in resonance, the YIG oscillating circuit becomes only strip line with front end shortcircuited and therefore $\Gamma_Y$ follows locus shown by A in Fig. 8. As clearly seen from Fig. 8, since phase condition of oscillation shown by formula (5) is not satisfied by $\Gamma_N$ of any amplitude, oscillation does not occur.

If the YIG element 55 resonates at frequency $f_0$ between $f_1$ and $f_2$ by application of d.c. magnetic field, $_Y$ follows locus shown by B in Fig. 8 at frequency near $f_0$. Then, at frequency near $f_0$, amplitude condition of formula (7) for oscillation to rise and phase condition of formula (5) are satisfied simultaneously. If the oscillation rises and $1/\Gamma_N$ is transferred from C state to D state, since formulae (4) and (5) are simultaneously satisfied at frequency $f_0$, steady oscillation is effected at the oscillation frequency $f_0$.

Based on such principle, if d.c. applied magnetic field is varied and resonance frequency of the YIG element is varied between $f_1$ and $f_2$, the oscillating circuit oscillates in tuning to frequency near the resonance frequency.

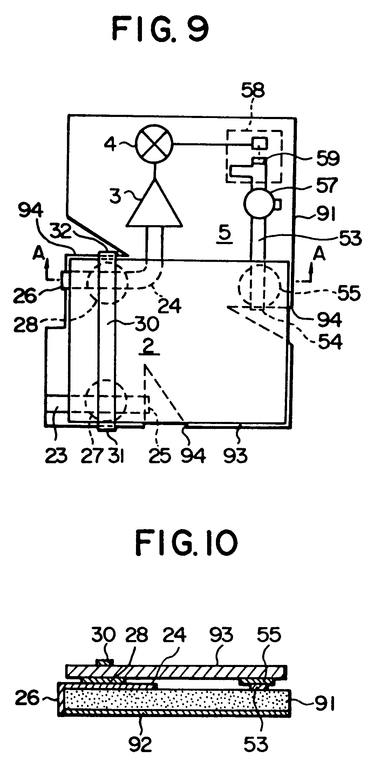

In an example of Figs. 2 and 3 and an example of Figs. 4 and 5, the filter circuit 2 and the local oscillator 5 are formed on the separate substrates 21 and 51. However, the signal converter as a whole may be formed integrally on a single substrate. An example of such constitution is shown in Fig. 9 and Fig. 10. Fig. 9 is a plan view of a signal converter, and Fig. 10 is a sectional view taken on line A-A of Fig. 9. Parts in Fig. 9 and Fig. 10 corresponding to Fig. 1 through Fig. 5 are designated by the same reference numerals, and the repeated description shall be omitted. In this case, the above-mentioned substrates 21 and 51 are replaced by a common substrate 91 made of alumina for example. One major surface of the common substrate 91 has a filter circuit 2, an amplifier 3, a mixer 4 and a local oscillator 5 formed thereon, and other major surface has a common ground conductor 92 adhered thereon in place of the ground conductors 22 and 52. The GGG substrates 29 and 56 are replaced by a common GGG substrate 93, and YIG thin film elements 27, 28 and 55 are formed on the substrate 93. In a notch 94 provided on the substrate 91, ends of micro strip lines 23, 24 and 53 are connected to the ground conductor 92 through connecting conductors 25, 32 and 54 respectively.

The GGG substrate may be provided with recesses corresponding to shape and size of various YIG thin film elements, and the YIG thin film elements may be disposed in respective recesses.

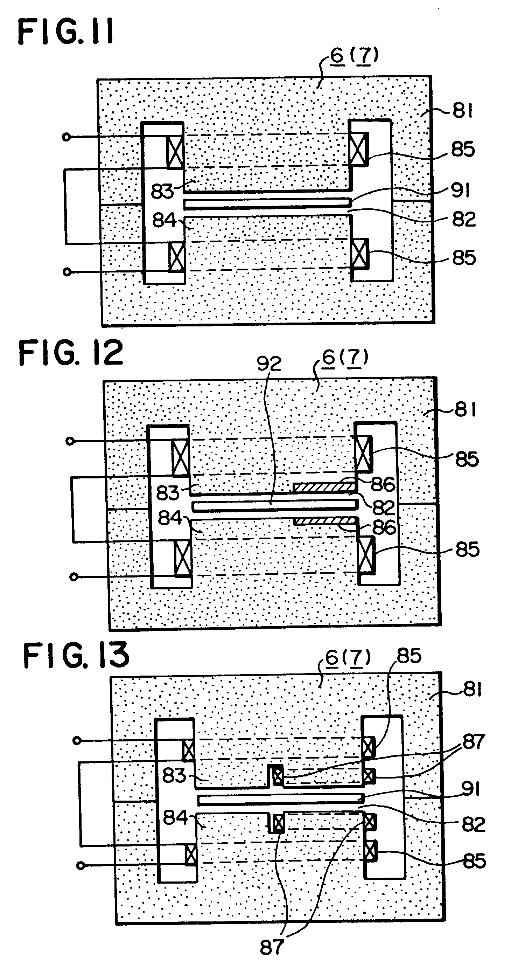

Although magnetic field may be applied to the YIG thin film magnetic resonance elements 27, 28 and 55 of the filter circuit 2 and the local oscillator 5 by respective magnetic field applying means 6 and 7 as above described, the means 6 and 7 may be constituted commonly. For example, a yoke 81 of magnetic substance such as permalloy is installed as shown in Fig. 11, and in a magnetic gap 82 of the yoke 81 is disposed a substrate 91 on which the signal converter circuit as described in Fig. 9 and Fig. 10 is assembled. A coil 85 is wound on at least one of opposite magnetic poles 83 and 84 to constitute the magnetic gap 82 of the yoke 81, and the magnetic field applying means 6 and 7 are constituted commonly. Thus, the common magnetic field is applied to the YIG thin film elements 27, 28 and 55 of the filter circuit 2 and the local oscillator 5. This constitution can be applied to the case where the offset frequency is obtained by varying the aspect ratio in the YIG elements 27, 28 and 55. When different magnetic fields are applied to the YIG elements 27, 28 and 55 so as to obtain the offset frequency, as shown in Fig. 12 and Fig. 13, a permanent magnet 86 is locally arranged on at least one of the magnetic poles 83 and 84, or an auxiliary coil 87 is arranged there. Magnetic field from the magnet 86 or the coil 87 is superposed on magnetic field from the coil 85 in forward direction or reverse direction so that in the magnetic gap 82 the magnetic field intensity at the installation position of the magnet 86 or the coil 87 is different from that at other position by a prescribed amount, and the YIG elements 27, 28 of the filter circuit and the YIG element 55 of the local oscillator are arranged at positions different in the magnetic field intensity.

When the offset frequency is varied thereby the intermediate frequency to be taken out from the mixer 4 is varied as in a receiver used in amateur radio communication, current flowing through the auxiliary coil 87 for example may be adjusted so as to adjust difference between magnetic fields applied to respective YIG elements of the filter circuit and the local oscillator.

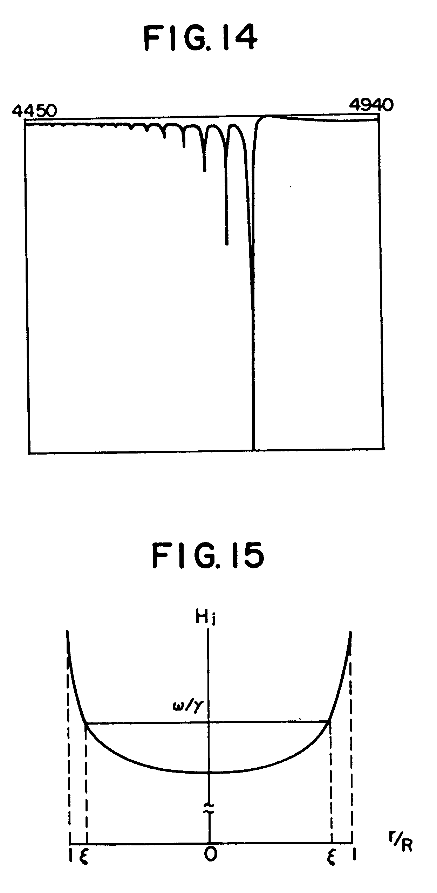

In the invention as above described, each resonator of the filter circuit 2 and the local oscillator 4 is constituted by a thin film element produced in thin film forming method to a magnetic resonance element. Suppression of spurious response (magnetostatic mode) is required in this case. The magnetic resonance element by monocrystalline sphere(YIG monocrystalline sphere) is advantageous in that magnetostatic mode is not easily excited thereby single resonance mode of uniform precessional mode is obtained. However, even if the YIG thin film is located in the high-frequency magnetic field of good uniformity, since the internal d.c. magnetic field is not uniform, magnetostatic mode may be much excited. Magnetostatic mode when d.c. magnetic field is applied perpendicularly to surface of a ferrimagnetic specimen of disk shape is analyzed in the reference (Journal of Applied Physics, vol. 48, July 1977, pp. 3001 - 3007), and each mode is expressed by $(n, N)_m$. Wherein mode $(n, N)_m$ is a mode having n nodes in the circumferential direction, N nodes in the diameter direction, band (m-1) nodes in the thickness direction. If the high-frequency magnetic field has good uniformity throughout the specimen,$(1, N)_1$ series becomes principal magnetostatic mode. Fig. 14 shows measuring results of ferrimagnetic resonance of a circular YIG thin film specimen measured in a cavity resonator of 9 GHz. It is seen from the figure that magnetostatic mode of $(1, N)_1$ series is much excited. When microwave element such as filter is constituted using the specimen, mode $(1, 1)_1$ being main resonance mode is utilized and other magnetostatic mode entirely becomes spurious response, thereby signal of undesired frequency may be passed or S/N ratio may be reduced. In the local oscillator 5, the oscillation in undesired frequency may cause shift of the intermediate frequency from the mixer 4. Consequently, in each ferrimagnetic thin film (YIG thin film magnetic resonance element), it in required that excitation of magnetostatic mode becoming spurious response is suppressed without deteriorating main response mode. Means for such suppression will now he described.

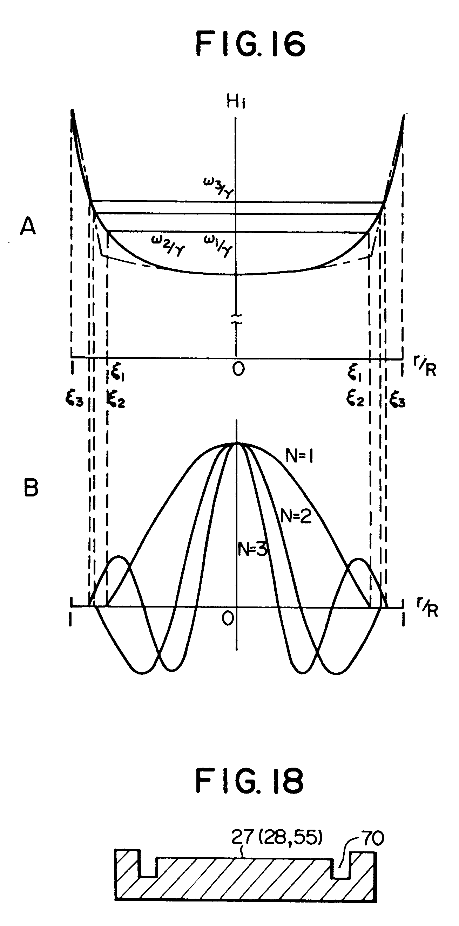

Fig. 15 shows state of internal d.c. magnetic field Hi when d.c. magnetic field is applied in perpendicular direction to surface of a disk shaped YIG thin film with thickness t and diameter D (radius r). Wherein the aspect ratio t/D is sufficiently small to neglect distribution of the magnetic field in the specimen thickness direction. Since demagnetizing field is large at inside of the disk and abruptly becomes small at the periphery the internal d.c. magnetic field is small at portion near the center and abruptly becomes large near the periphery. According to the analysis result in the reference, if value of r/R at position of $Hi = \omega/\gamma$ is

assumed $\xi$, magnetostatic mode exists at region where $O \leq r/R \leq \xi$. Wherein $\omega$: resonant angular frequency of magnetostatic mode, $\gamma$ : gyromagnetic ratio. When the magnetic field is fixed, as the mode number N becomes large, the resonance frequency becomes high and region of magnetostatic mode expands outwards as shown in Fig. 16A. Fig. 16B shows distribution of RF magnetization within the specimen in low-order three modes of $(1, N)_1$ modes, and absolute value represents amount of RF magnetization and sign represents phase relation of RF magnetization. As clearly understood from Fig. 16, RF magnetization component has different forms depending on the magnetostatic mode. Utilizing this, excitation of magnetostatic mode becoming spurious response can be suppressed without a significant effect on the major resonance mode.

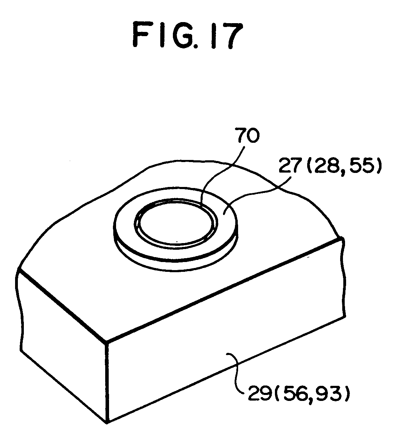

More specifically, as shown in Fig. 17, YIG thin film element 27, 28 or 55 of circular shape is formed on the GGG substrate 29, 56 or 93, and an annular groove 70 is formed on the thin film element by means of selective etching for example so as to form an annular thin portion. In this case, each YIG thin film element is sufficiently thin and the magnetostatic mode is $(1, N)_1$ mode.

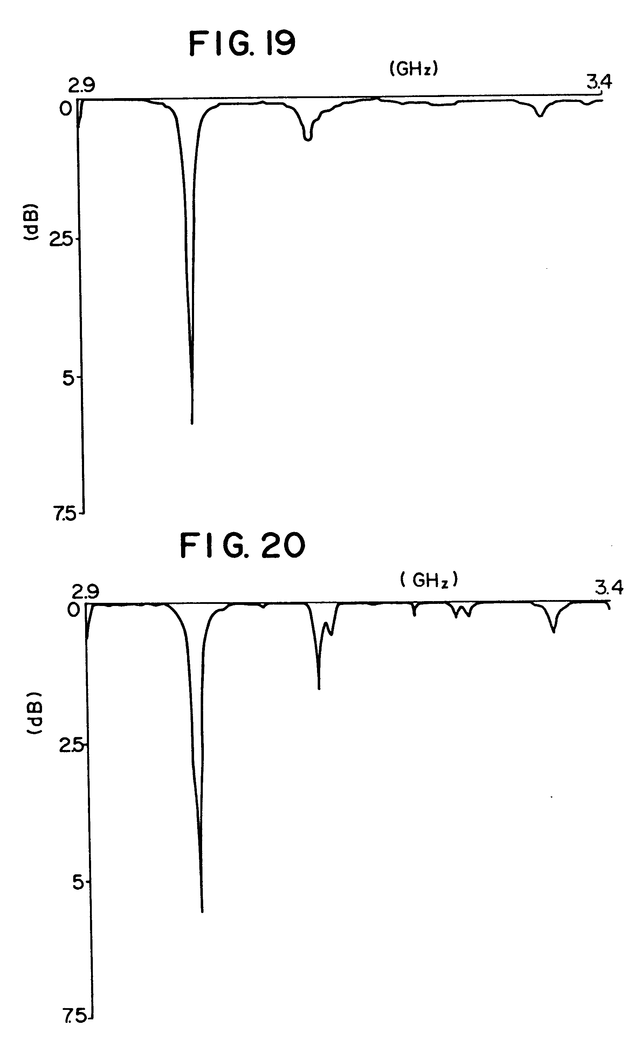

The groove 70 is formed in concentric relation on position where RF magnetization of $(1, 1)_1$ mode becomes zero. The groove as a whole may be continuous or diskontinuous. As shown in Fig. 18, region enclosed by the groove 70 may be made thin in comparison to outside region. In this case, demagnetizing field is elevated at inside region close to the groove 70, and becomes nearly uniform to this region. In other words, the internal d.c. magnetic field becomes nearly uniform throughout wide region in the radial direction as shown in dash-and-dot line of Fig. 16A. Consequently, excitation of magnetostatic mode other than the main resonance mode can be further suppressed.

In such magnetic resonance element, the magnetization is restricted by the groove 70. Since the groove 70 exists at position where the RF magnetization becomes zero to $(1, 1)_1$ mode, excitation of $(1, 1)_1$ mode is not affected. On the contrary, since the RF magnetization to other mode is not essentially zero at the position of the groove 70, the magnetization is partially accelerated thereby excitation of such mode is reduced. Consequently, the spurious response can be suppressed without deteriorating the main resonance mode.

Since distribution of RF magnetization in the YIG thin film (refer to Fig. 16B) has no relation to amount of saturated magnetization of the specimen and is not largely dependent on the aspect ratio, even if the saturated magnetization or the film thickness of the ferrimagnetic layer is different, position of the groove need not be varied corresponding to the difference.

In this connection, YIG thin film element of film thickness $20\mu m$ and radius 1mm was produced from YIG thin film and a groove 70 of depth $2\mu m$ was formed on position of radius 0.8mm of the element, and ferromagnetic resonance regarding the specimen was measured using micro strip lines, thereby measuring results of the insertion loss were obtained as shown in Fig. 19. Unloaded Q value was 775.

In a circular YIG thin film resonance element, the RF magnetization of $(1, 1)_1$ mode was zero at position of $r/R = 0.8$.

On the contrary, YIG thin film element of film thickness $20\mu m$ and radius 1 mm without groove was produced from the same YIG thin film, and ferromagnetic resonance regarding the specimen was measured using micro strip lines. The measuring results of the insertion loss were obtained as shown in Fig. 20. Unloaded Q value was 660. As clearly understood from comparison of both cases, the invention can suppress excitation of magnetostatic mode other than $(1, 1)_1$ mode and also suppress the spurious response. Since the main resonance mode is not deteriorated, the unloaded Q value is not deteriorated.

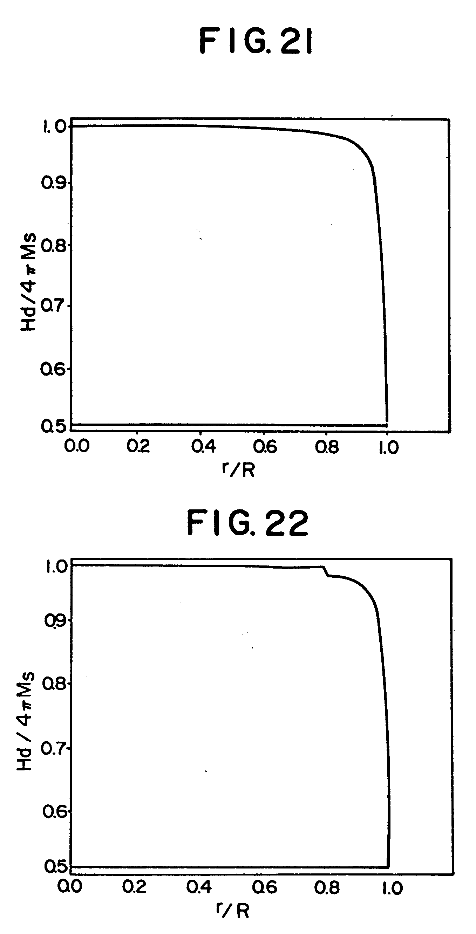

In order to suppress excitation of magnetostatic mode becoming spurious response in a magnetic resonance element by YIG thin film, i.e. ferrimagnetic thin film, inside region of the ferrimagnetic thin film may be made thinner than outside region. Such constitution will now be described. If d.c. magnetic field Ho is applied in perpendicular direction to film surface of the disk shaped YIG thin film of thickness t and diameter D (radius r), internal d.c. magnetic field Hi becomes Hi = Ho-Hd(r/R)-Ha. Wherein Hd is demagnetizing field, and Ha is anisotropic magnetic field. The aspect ratio t/D is sufficiently small and distribution of the magnetic field in the specimen thickness direction is neglected. Fig. 21 shows calculated value of demagnetizing field Hd of the YIG disk of radius 1mm. Since the demagnetizing field is large at inside of the disk and abruptly becomes small at the periphery, the internal d.c. magnetic field is small at portion near the center and abruptly becomes large near the periphery. On the contrary, Fig. 22 shows calculated value of the demagnetizing field of the YIG thin film where the film thickness within region of inside radius 0.8mm is made thinner by $1\mu m$. It is seen from the figure that as the film thickness at inside region is made a little thinner the demagnetizing field is a little elevated at portion near the periphery of the thinned region and flat region of the demagnetizing field is enlarged.

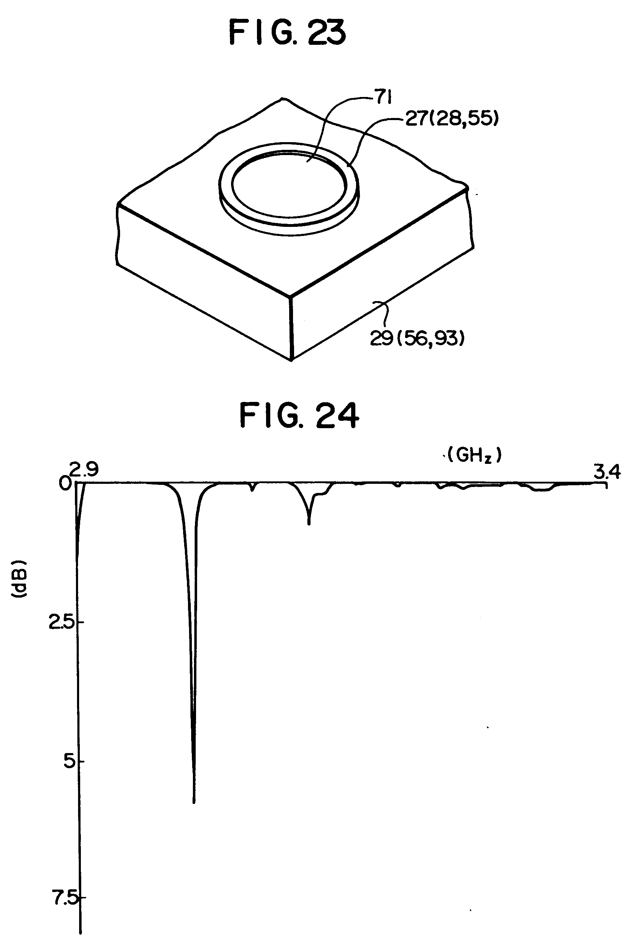

Consequently, if the inside region of the YIG thin film element is made thinner than the outside region, flat region of the demagnetizing field in the inside region can be enlarged thereby magnetostatic mode to cause the spurious response can be suppressed. As shown in Fig. 23, the ferrimagnetic YIG thin film element 27, 28 or 55 is formed on the GGG substrate 29, 56 or 93. A recess 71 is formed on the YIG thin film element 27, 28 or 55 thereby the inside region is made thinner than the outside region. Thickness of the YIG thin film element 27, 28 or 55 is made sufficiently small so that distribution of the magnetic field in the thickness direction becomes uniform. The magnetostatic mode is $(1, N)_1$ mode.

The recess 71 is extended to position where excitation of the magnetostatic mode to cause the spurious response is sufficiently suppressed. It is preferably extended to position where amplitude of $(1, 1)_1$ mode becomes zero. For example, if the YIG thin film is disk shape, the recess is extended to position of (0.75 - 0.85)times as large as the radius.

In this connection, YIG thin film magnetic resonance element of film thickness $20\mu$m and radius 1mm was formed and a circular recess 71 of depth $1.7\mu$m and radius 0.75mm was formed on the resonance element in concentric relation, and ferromagnetic resonance regarding the specimen was measured using micro strip lines, thereby measuring results of the insertion loss were obtained as shown in Fig. 24. Unloaded Q value was 865.

Resonance frequency by a magnetic resonance element such as YIG thin film element is dependent on the saturation magnetization of the element and therefore affected directly by temperature characteristics of the saturation magnetization. If resonance frequency of the YIG thin film elements 27 and 28 in the high-frequency filter circuit 2 is varied depending on variation of the ambient temperature, the tuned frequency will get out of order. Consequently, the YIG thin film element in the filter circuit 2 and the YIG thin film element in the local oscillator to hold a definite offset frequency are preferably held to the resonance frequency irrespective of the ambient temperature. In order to hold the resonance frequency $f_o$ of the YIG thin film in vertical resonance irrespective of the temperature T, the element may be disposed in a thermostat so as to hold the element itself to a constant temperature or prescribed d.c. magnetic field depending on the resonance frequency $f_o$ may be applied so as to supply variation amount of the magnetic field matched to variation amount of the saturated magnetization $4\pi M_s$ [gauss] of the YIG depending on the temperature. If the YIG element is disposed at the magnetic gap in the magnetic circuit, the magnetic field $H_g$ in the magnetic gap becomes

$$H_g \ (T) \ = \ \frac{\dot{f}_o}{\gamma} \ + \ N_{zy} \cdot 4\pi M_{sy} \ (T) \tag{8}$$

wherein $N_{zy}$: demagnetizing factor, $\gamma$ : gyromagnetic ratio. Consequently, if the $H_g(t)$ is varied in matching to the saturation magnetization $4\pi M_{sy}(T)$ of the YIG varying corresponding to variation of the temperature T, the resonance frequency $f_o$ can be held constant. In order to vary the magnetic field corresponding to temperature variation of the YIG element, an electromagnet may be used or combination of a permanent magnet and a soft magnetic plate may be used.

In the case of using the electromagnet and also using the thermostat, however, current control is performed by external energy supply and therefore the constitution becomes complicated.

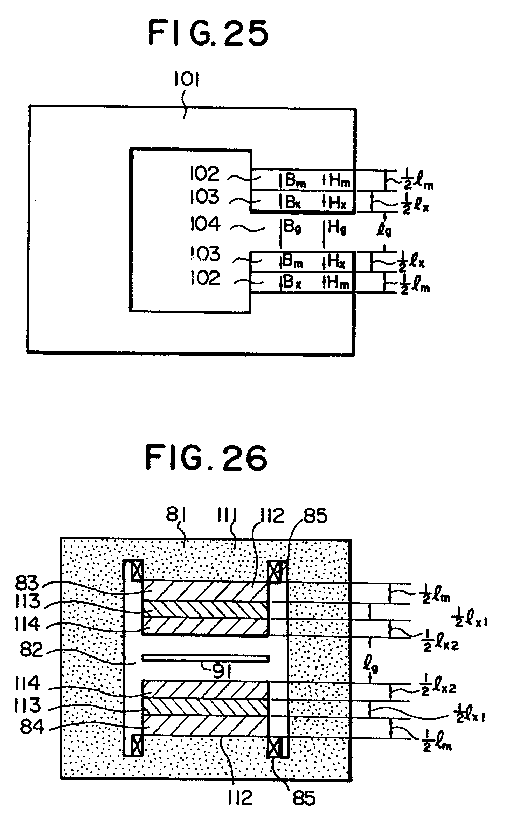

One method to control temperature characteristics of the gap magnetic field $H_g$ by combination of the permanent magnet and the soft magnetic plate is in that temperature characteristics of the gap magnetic field $H_g$ are designed by superposition of temperature characteristics of the used permanent magnet and temperature characteristics of magnetization of the soft magnetic plate in matching to temperature characteristics of a ferromagnetic resonance element such as YIG element, thereby temperature dependence of the resonance frequency of the element is compensated and the resonance frequency $f_o$ is held constant in the wide temperature range. Referring to Fig. 25, each of opposite ends of a C-shaped yoke 101 has a permanent magnet 102 and a soft magnetic plate 103 formed of soft magnetic alloy or ferrite. A magnetic gap 104 of distance $\ell_g$ is formed between both of the soft magnetic plates 103 so as to constitute a magnetic circuit. Wherein $\ell_m$: sum of thickness of both magnets 102, $\ell_x$: sum of thickness of both soft magnetic plates 103, $B_m$ and $H_m$: magnetic flux density and magnetic field within the magnet 102, $B_x$ and $H_x$: magnetic flux density within the soft magnetic plates 103, $B_g$ and $H_g$: magnetic flux density and magnetic field within the magnetic gap 104. Since the permanent magnet 102 is situated in demagnetizing field, the magnetic field $H_m$ is in reverse direction to the magnetic flux density $B_m$. Following description is in c.g.s unit system. Maxwell's equations regarding magnetic flux density and magnetic field in such magnetic circuit are expressed as follows:

8

$$\iiint_V \text{div}\, \mathbb{B} \cdot d_W = \iint_S \mathbb{B} \cdot d_S = 0 \qquad (9)$$

$$\iint_S \text{rot}\, \mathbb{H} \cdot d_S = \oint_C \mathbb{H} \cdot d_\ell = 0 \qquad (10)$$

Assuming that the magnetic field and the magnetic flux density within the magnet and the soft magnetic plate are uniform and there is no leakage of the magnetic flux to circumstances, equations (9) and (10) are expressed as follows:

$$B_m = B_x = B_g \qquad (11)$$

$$\ell_m \cdot H_m = \ell_g \cdot H_g + \ell_x \cdot H_x \qquad (12)$$

If intensity of magnetization of the soft magnetic plate is $4\pi M_x$, the internal magnetic field $H_x$ of the soft magnetic plate is expressed by following formula. If the internal magnetic field of the soft magnetic plate is sufficiently strong, $4\pi M_x$ in following formula becomes the saturated magnetization $4\pi M_{sx}$.

$$H_x = H_g - N_{zx} \cdot 4\pi M_{sx} \qquad (13)$$

Wherein $N_{zx}$ is demagnetization factor, and if the soft magnetic plate is a thin disk of diameter $D_s$ and thickness $S(=1/2\ \ell_x)$, $N_{zx}$ is approximately expressed as follows:

$$N_{zx} = 1 - \frac{S/D_s}{\{1 - (S/D_s)^2\}^{1/2}} \qquad (14)$$

Substituting formula (13) to formula (12), the gap magnetic field $H_g$ is expressed by following formula.

$$H_g = \frac{\ell_m \cdot H_m + \ell_x\, N_{zx} \cdot 4\pi M_{sx}}{\ell_g + \ell_x} \qquad (15)$$

Wherein $N_{zx}$: demagnetization factor of the soft magnetic plate. Consequently, using the internal magnetic field $H_m(T)$ of the magnet and the intensity of magnetization $4\pi M_{sx}(T)$ of the soft magnetic plate at the temperature T, the gap magnetic field $H_g$ as function of the temperature T is expressed by following formula.

$$H_g(T) = \frac{\ell_m \cdot H_m(T) + \ell_x \cdot N_{zx} \cdot 4\pi M_{sx}(T)}{\ell_g \quad \ell_x} \qquad (16)$$

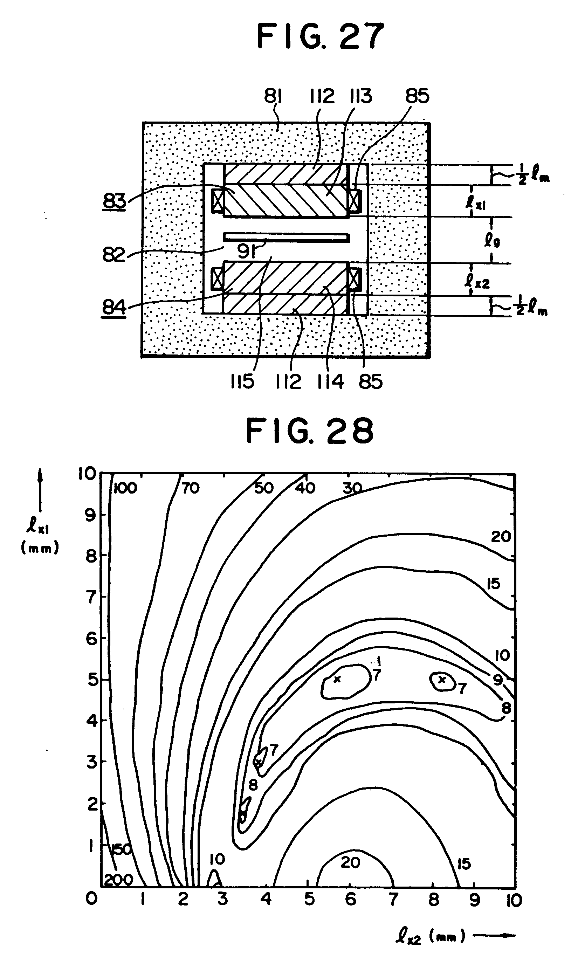

Consequently, in formula (16), if characteristics and size of the magnet 102, i.e. $H_m$ and $\ell_m$, and characteristics and size of the soft magnetic plate, i.e. $4\pi M_x$, $N_{zx}$ and $\ell_x$, and the gap distance $\ell_g$ are selected, the most suitable $H_g$ can be obtained. Composition and sintering condition of constituting material of the soft magnetic plate 103, such as ferrite or composition of alloy is selected, or the soft magnetic plate is constituted by two kinds or more. However, even if composition of the soft magnetic plate and the manufacturing conditions such as sintering condition are selected as above described, it is quite difficult in practice that the temperature characteristics including inclination and curvature coincide with the desired temperature characteristics. Consequently, the resonance frequency $f_o$ of the ferromagnetic resonance element such as YIG element cannot be held constant in wide temperature range. On the other hand, compensation of the temperature dependence in the YIG resonance element is possible in a process that the magnetic circuit which supplies the d.c. magnetic field to the YIG resonance element, for example, the magnetic yoke 81 described in Fig. 11 through Fig. 13, is assembled with material having similar composition and preferably the same composition as that of the YIG thin film element, that is, material whose temperature characteristics are the same as or similar to that of the YIG thin film element. Such constitution will be described referring to Fig. 26 and Fig. 27. In a yoke 81 of this case, magnetic poles 83 and 84 to constitute a magnetic gap 82 in which the YIG thin film element is arranged have special constitution. More specifically, magnets 112 are attached to opposite sides of the yoke 81, and first and second soft magnetic plates 113 and 114 having different composition from that of the magnet 112 are attached to respective magnets 112. In an example of Fig. 26, the first and second soft magnetic plates 113 and 114 are arranged to each of both sides with respect to the magnetic gap 82. In an example of Fig. 27, the first and second soft magnetic plates 113 and 114 are arranged respectively to both sides with respect to the magnetic gap 82.

One soft magnetic plate, e.g. the first soft magnetic plate 113, is made of YIG plate having the same composition as that of the YIG element, and other soft magnetic plate, e.g. the second soft plate plate 114, is made of other magnetic substance such as ferrite plate. In Fig. 27, when the first soft magnetic plate 113 is made of YIG and the second soft magnetic plate 114 is made of Mg•Mn•Al ferrite, and the magnet 112 is a permanent magnet of $SmCo_5$ with diameter 30mm (residual magnetic flux density Br = 8134G, coercive force $H_c$ = 78760$_e$, temperature coefficient $\alpha$ = -0.0005, exponential temperature characteristics), and distance of the magnetic gap 82 is made $\ell_g$ = 2mm and the YIG thin film element of diameter 2mm and thickness 20$\mu$m is disposed within the gap 82, energizing of the coil 85 was interrupted and thickness $\ell_m$ of the magnet 112 was selected so that the resonance frequency $f_o$ becomes $f_o$ = 3GHz and the YIG thin film element was resonated. When the ambient temperature was varied in range of - 20°C - #60°C, frequency deviation $\Delta f$ (±MHz) to the resonance frequency $f_o$ relating to thickness $\ell_{x1}$ and $\ell_{x2}$ of the first and second soft magnetic plates 113 and 114 was measured as shown in Fig. 28 where points having the same frequency deviation $\Delta f$ are connected in equi-value line. In Fig. 28, numeral written on each equi-value line represents value of $\Delta f$ (±MHz). In Fig. 28, ordinate represents thickness $\ell_{x1}$ of the first soft magnetic plate 113, and abscissa represents thickness $_{x2}$ of the second soft magnetic plate 114. It is clearly seen from Fig. 28 that use of two sorts of the soft magnetic plates can reduce the temperature dependence of the resonance frequency in comparison to use of single soft magnetic plate as described in Fig. 25. Table 1 shows values regarding thickness $\ell_m$ of the magnet, thickness $\ell_{x1}$ of the YIG soft magnetic plate, thickness $\ell_{x2}$ of the ferrite soft magnetic plate and frequency deviation $\Delta f$.

Table 1

| $\ell_m$(mm) | $\ell_{x1}$(mm) | $\ell_{x2}$(mm) | $\Delta f$(±MHz) |
|---|---|---|---|
| 3.25 | 3.00 | 3.81 | 6.381 |
| 5.75 | 5.04 | 8.24 | 6.703 |
| 4.60 | 4.99 | 5.66 | 6.143 |
| 2.80 | 1.82 | 3.44 | 7.104 |
| 2.13 | 0 | 2.83 | 9.397 |

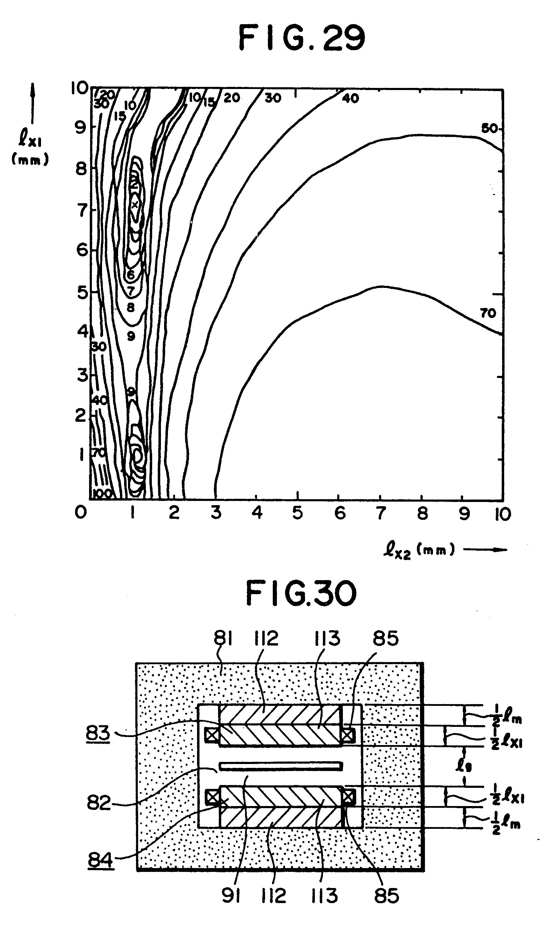

When similar constitution to the above example was taken and the magnet 112 was a permanent magnet of $CeCo_5$ (Br = 6250G, $H_c$ = 62500e, $\alpha$ = -0.0009, approximately linear temperature characteristics), frequency deviation $\Delta f$ relating to thickness $\ell_{x1}$ and $\ell_{x2}$ of the first and second soft magnetic plates 113 and 114 was measured as shown in Fig. 29. For example, if $\ell_m$ = 2.44mm, $\ell_{x1}$ = 0.89mm and $\ell_{x2}$ = 0.98mm, $\Delta f$ = becomes $\Delta f$ = 2.160MHz. If $\ell_m$ = 5.11mm, $\ell_{x1}$ = 7.10mm and $\ell_{x2}$ = 0.95mm, $\Delta f$ becomes $\Delta f$ = 0.786MHz. In this case, too, $\Delta f$ can be decreased by combination of the ferrite soft magnetic plate and the YIG soft magnetic plate. This example having the magnet 3 of $\alpha$ = -0.0009 can decrease $\Delta f$ well in comparison to the previous example of $\alpha$ = -0.0005.

Further, when the magnet 112 was a permanent magnet of $\alpha$ = -0.001 (Br = 6300G, $H_c$ = 55000e, linear temperature characteristics) and only the first soft magnetic plate 113 of YIG was used as shown in Fig. 30, if $\ell_m$ = 3.281mm and $\ell_{x1}$ = 3.857mm, $\Delta f$ becomes $\Delta f$ = 2.224MHz.

In conclusion, as temperature coefficient of the permanent magnet 112 approaches the average temperature coefficient -0.00128 estimated by formula (8), frequency deviation Δf, i.e. temperature dependence can be reduced when the soft magnetic plates is constituted by YIG only. When two sorts of soft magnetic plates are used, f can be reduced if one of the soft magnetic plates is made of the same material as that of the magnetic resonance element.

Temperature dependence of the resonance frequency can be reduced if the same YIG as that of the magnetic resonance thin film element is used in a soft magnetic plate as above described. This constitution will be described.

In order to realize the ideal state that the temperature dependence becomes 0, the formula (8)

$$H_g(T) = \frac{f_o}{\gamma} + N_{zy} \cdot 4\pi M_{sy}(T)$$

and the formula (16)

$$H_g(T) = \frac{\ell_m H_m(T) + \ell_x \cdot N_{zx} \cdot 4\pi M_{sx}(T)}{\ell_g \quad \ell_x}$$

must be equal. Hence

$$\frac{f_o}{\gamma} + N_{zy} \cdot 4\pi M_{sy}(T)$$

$$= \frac{\ell_m}{\ell_g + \ell_x} H(T) + \frac{\ell_x}{\ell_g + \ell_x} N_{zx} \cdot 4\pi M_{sx}(T) \qquad (17)$$

If temperature coefficient of the permanent magnet is quite small and $H_m(T)$ is made the constant value $H_{mo}$, it follows that

$$\frac{f_o}{\gamma} + N_{zy} \cdot 4\pi M_{sy}(T)$$

$$= \frac{\ell_m}{\ell_g + \ell_x} H_{mo} + \frac{\ell_x}{\ell_g + \ell_x} N_{zx} \cdot 4\pi M_{sx}(T) \qquad (18)$$

In order that both sides are always equal, the constant terms must be equal and the temperature dependent terms be equal respectively. Hence

$$\frac{f_o}{\gamma} = \frac{\ell_m}{\ell_g + \ell_x} H_{mo} \qquad (19)$$

$$N_{zy} \cdot 4\pi M_{sy}(T)$$

$$= \frac{\ell_x}{\ell_g + \ell_x} N_{zx} \cdot 4\pi M_{sx}(\dot{T}) \tag{20}$$

From formula (19), it follows that

$$H_{mo} = \frac{\ell_g + \ell_x}{\ell_m} \cdot \frac{f_o}{\gamma} \tag{21}$$

Since the YIG element and the soft magnetic plate are sufficiently thin and therefore $N_{zy}$ and $N_{zx}$ become approximately 1 respectively, formula (20) becomes

$$4\pi Msy(T) = \frac{\ell_x}{\ell_g + \ell_x} 4\pi Msy(T) \tag{22}$$

Further, assuming that $\ell_g \ll \ell_x$, it follows that $\ell_x/\ell_g + \ell_x \sim 1$ and formula (20) becomes

$$4\pi\, Msy\,(T) = 4\pi\, Msx\,(T) \tag{23}$$

Consequently, if characteristics of the permanent magnet 113 are constant irrespective of temperature and distance $\ell_g$ of the magnetic gap 82 is sufficiently small, the soft magnetic plate to equalize formula (8) and formula (15) is YIG as constituting material of the magnetic resonance element itself.

Next, description is in that if the permanent magnet has temperature coefficient $\beta$ and YIG as constituting material of the magnetic resonance element is used in the soft magnetic plate the temperature characteristics will become quite well.

When YIG is used in the soft magnetic plate, formula (17) is obtained by equalizing formula (8) and formula (16), and further $N_{zx}$, $N_{zy} \sim 1$. Consequently, formula (17) is solved regarding $H_m(T)$ as follows:

$$Hm(T) = \frac{\ell_g + \ell_x}{\ell_m} \cdot \frac{fo}{\gamma} + \frac{\ell_g}{\ell_m} \cdot 4\pi\, Msy\,(T) \tag{24}$$

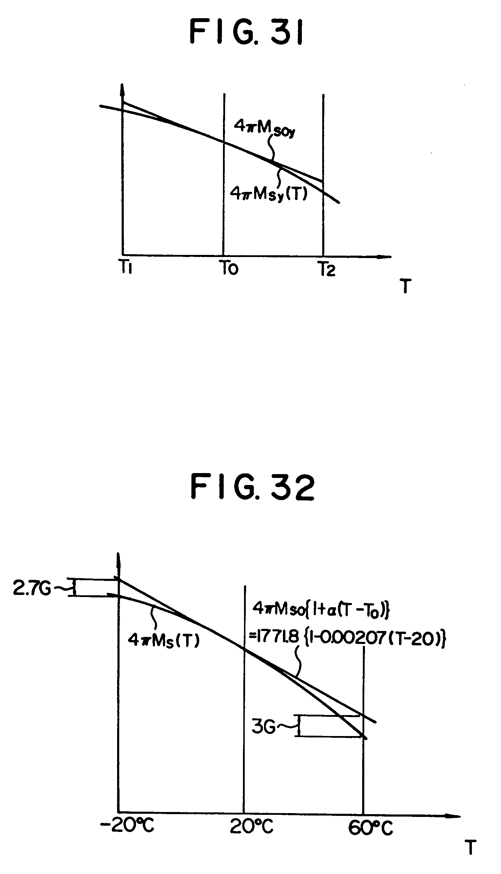

Referring to Fig. 31, if temperature characteristics of the saturation magnetization are represented by line approximately using the average temperature coefficient a in the noticed temperature range $T_1 \sim T_2$, it follows that

$$4\pi\, Msy\,(T)$$

$$= 4\pi\, Msoy\, \{1 + \alpha\,(T - To)\} \tag{25}$$

Substituting formula (25) in formula (24),

$$Hm \ (T) \ = \ \frac{\ell_g + \ell_x}{\ell_m} \ \cdot \ \frac{fo}{\gamma} \ + \frac{\ell_g}{\ell_m} \cdot 4 \ Msoy$$

$$+ \frac{\ell_g}{\ell_x} \cdot 4\pi \ Msoy \ \alpha(T - To) \qquad (26)$$

Hence

$$Hm \ (T) \ = \ Hmo \ \{1 \ + \ \beta(T - To)\} \qquad (27)$$

wherein

$$Hmo \ = \ \frac{\{( \ \ell_g + \ell_x \ ) \ fo/\gamma\} + \ \ell_g \ \cdot \ 4\pi \ Msoy}{\ell_m} \qquad (28)$$

$$\beta \ = \ \frac{\ell_g \ \cdot \ 4\pi \ Msoy}{\{( \ \ell_g + \ell_x \ ) \ fo/\gamma\} \ + \ \ell_g \ \cdot \ 4\pi \ Msoy} \cdot \alpha$$

$$= \ \frac{4\pi \ Msoy}{\{(1 \ + \ \ell_x/ \ \ell_g) \ fo/\gamma\} \ + \ 4\pi \ Msoy} \cdot \alpha \qquad (29)$$

If the permanent magnet has linear temperature characteristics and the temperature coefficient is $\beta$, in order that formula (29) is satisfied, following formula is selected.

$$\ell_x \ / \ \ell_g \ = \ \frac{(\alpha \ - \ \beta) \ 4\pi \ Msoy}{\beta \ \cdot \ fo/\gamma} \ 1 \qquad (30)$$

Further, in order that formula (28) is satisfied, following formula is selected corresponding to strength $H_{mo}$ of the permanent magnet.

$$\ell_m \ \cdot \ Hmo \ = \ \{( \ell_g + \ell_x) \ fo/\gamma\}$$

$$+ \ \ell_g \ \cdot \ 4\pi \ Msoy \qquad (31)$$

Then the gap magnetic field H(T) becomes

$$Hg \ (T)$$

$$= \frac{\ell_m}{\ell_g + \ell_x} Hm \ (T) + \frac{\ell_x}{\ell_g + \ell_x} 4\pi \ Msy \ (T)$$

$$= \frac{\ell_m}{\ell_g + \ell_x} Hmo \ \{1 + \beta(T - To)\}$$

$$+ \frac{\ell_x}{\ell_g + \ell_x} 4\pi \ Msy \ (T)$$

$$= \frac{\ell_m}{\ell_g + \ell_x} \cdot \frac{\ell_g + \ell_x}{\ell_m} \cdot \frac{fo}{\gamma} + \frac{\ell_g}{\ell_m} \cdot 4\pi \ Msoy$$

$$+ \frac{\ell_g}{\ell_m} \cdot 4\pi \ Msoy \cdot \alpha(T - To)$$

$$+ \frac{\ell_x}{\ell_g + \ell_x} \cdot 4\pi \ Msy \ (T)$$

$$= \frac{fo}{\gamma} + \frac{\ell_g}{\ell_g + \ell_x} \cdot 4\pi \ Msoy \quad 1 + \alpha(T - To)$$

$$+ \frac{\ell_x}{\ell_g + \ell_x} \cdot 4\pi \ Msy \ (T) \qquad\qquad (32)$$

On the other hand, when $N_{zy} \sim 1$, the resonance frequency f becomes

$$f = \gamma \{H_g \ (T) - 4\pi \ Msy \ (T)\} \qquad (33)$$

From formulae (32) and (33), $\Delta f = f{-}f_o$ becomes

$$\Delta f = \frac{\gamma \ell_g}{\ell_g + \ell_x} [4\pi \ Msoy \ \{1 + \alpha(T - To)\}$$

$$- 4\pi \ Msy \ (T)] \qquad\qquad (34)$$

That is, $\Delta f$ is shift of $4\pi M_{sy}$ from the linear approximation, multiplied by $\ell_g/\ell_g + \ell_x$ times and further multiplied by $\gamma$. consequently, $\Delta f$ becomes quite small. For example, as shown in Fig. 32, at -20°C the measured value is 1915.8G and the value by linear approximation is 1918.5G, thereby the shift is as small as about 2.7G; at +60°C the measured value is 1622.1G and the value by linear approximation is 1625.1G, thereby the shift is as small as 3.0G. Assuming that $\ell_g/\ell_g + \ell_x = 0.2$ and $\gamma = 2.8$, it follows that

$\Delta f = 2.8 \times 0.2 \times 3.0 = 1.68$MHz

That is, $\Delta f$ becomes as small as 0.84MHz.

Thus, it is understood that if YIG is used in the soft magnetic plate the magnetic apparatus can be constituted with excellent temperature characteristics hence with good compensation to the temperature dependence.

When this constitution is applied to a signal converter of the invention in practice, the coil 85 is variably energized and magnetic field by the coil 85 is superposed with magnetic field by the magnet 112 and in some cases together with the auxiliary coil 87, the magnet 86 and the like, thereby the superposed magnetic field sets the resonance frequency or tuning frequency.

Although any of above examples uses the soft magnetic plate of one or two sorts of constituting materials, three sorts of constituting materials or more may be used.

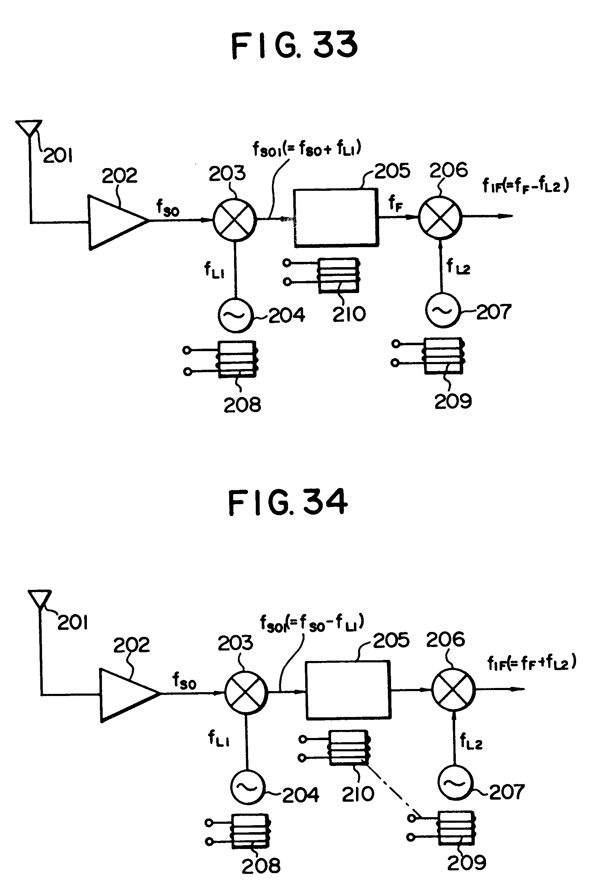

A signal converter of the invention is not restricted to a tuner of superheterodyne type as described in Fig. 1, but other constitutions such as a tuner of double superheterodyne type may be used. An example of this constitution will be described referring to Fig. 33. Numeral 201 designates an antenna, numeral 202 a high-frequency amplifier, numeral 203 a first mixer, numeral 204 a first local oscillator using a ferromagnetic resonator including YIG resonator element, numeral 205 a filter circuit by ferromagnetic resonator such as YIG resonator element, numeral 206 a second mixer, numeral 207 a second local oscillator also using a ferromagnetic resonator by including YIG resonator element, and numerals 208, 209 and 210 magnetic field applying means to YIG resonator elements of the first local oscillator 204, the second local oscillator 207 and the filter circuit 205, respectively. The magnetic field applying means 208 is variably constituted so that oscillation frequency of the first local oscillator 204, can be set variably. Other magnetic field applying means 210 and 209 supply fixed magnetic fields so that the passing frequency (center frequency) $f_F$ of the filter circuit 205 is set and the oscillation frequency $f_{L2}$ of the second local oscillator 207 is set to have a prescribed offset frequency. If the antenna 201 receives signal of frequency $f_{so}$, e.g. frequency $f_{so} = 90 \sim 900$MHz, the received signal is amplified by the amplifier 202 and introduced to the first mixer 203 and mixed by the mixer with oscillation signal of frequency $f_{L1}$, e.g. $f_{L1} = 2100$ 2910MHz from the first local oscillator 204, thereby signal converted in frequency $f_{so1}(f_{so1} = f_{so} + f_{L1})$ is taken out. Among the signal taken out from the first mixer 203, signal of intermediate frequency $f_F$ being passing frequency set in the filter circuit 205, e.g. $f_F = 3$GHz, is taken out from the filter circuit 205 and introduced to the second mixer 206 and mixed by the mixer with oscillation signal of frequency $f_{L2}$, e.g. $f_{L2} = 2942$MHz from the second local oscillator 207, thereby signal of frequency $f_{1F}(f_{LF} = f_F-f_{L2})$, e.g. $f_{1F} = 58$MHz is taken out. That is, the oscillation frequency $f_{L1}$ of the first local oscillator 204 is selected by adjusting the magnetic field applying means 208, thereby signal of a prescribed frequency is taken out among the receiving signal. For example, if oscillation frequency $f_{L1}$ of the first local oscillator 204 is selected to 2600MHz, receiving signal of $f_F-f_{L1} = 3000-2600 = 400$(MHz) can be tuned.

In such circuit constitution, too, magnetic resonance elements such as YIG element for the first local oscillator 204, the second local oscillator 207 and the filter circuit 205 are formed by the thin film forming method. The YIG thin film magnetic resonance elements are made of the same material and set to the same shape and aspect ratio. For example, if the element is of disk shape, ratio of radius is set to the same value; if the element is of square or rectangular shape, ratio of corresponding sides is set to the same value.

Thus, a receiver having excellent temperature characteristics in itself can be constituted. Consequently, compensation of the temperature characteristics by arranging the soft magnetic plate having the same composition as that of the YIG magnetic resonance thin film element in the magnetic circuit as described in Fig. 25 through Fig. 32 may be obviated. The temperature characteristics in such constitution will be described.

Resonance frequencies of YIG thin film resonator elements in the first local oscillator 204, the second local oscillator 207 and the filter circuit 205, that is, the oscillation frequencies $f_{L1}$ and $f_{L2}$ and the passing frequency $f_F$ of the filter circuit 205, are expressed as follows:

$$f_{L1} = \gamma(H_{ex1} - N_{z1}\, 4\pi\, M_{sy})$$
$$f_{L2} = \gamma(H_{ex2} - N_{z2}\, 4\pi\, M_{sy})$$
$$f_F = \gamma(H_{exF} - N_{zF}\, 4\pi\, M_{sy}) \qquad (35)$$

Wherein $H_{ex1}$, $H_{ex2}$, $H_{exF}$ are d.c. magnetic fields to YIG thin film elements in the first and second local oscillators 204, 207 and the filter circuit 205, and $N_{z1}$, $N_{z2}$, $N_{zF}$ are demagnetizing fastor of YIG thin film resonator elements in the first and second local oscillators 204, 207 and the filter circuit 205. In this

example, $H_{ex2}$ and $H_{exF}$ are fixed magnetic fields and $H_{ex1}$ is variable, and $N_{Z1}$, $N_{Z2}$, $N_{ZF}$ are selected so that $N_{Z1} = N_{Z2} = N_{ZF}$. When the ambient temperature varies, the saturated magnetization $4\pi M_{sy}$ of YIG as function of temperature varies, but on account of selection in $N_{Z1} = N_{Z2} = N_{ZF}$ the frequencies $f_{L1}$, $f_{L2}$, $f_F$ are varied by the same amount. For example, assuming that the passing frequency $f_F$ of the filter circuit 205 at the normal temperature is set to $f_F = 3GHz$, the oscillation frequency $f_{L2}$ of the second local oscillator 207 is set to 2.942GHz, and the oscillation frequency $f_{L1}$ of the first local oscillator 204 is set to 2.6GHz as already described for tuning in 400MHz, if the ambient temperature rises and $M_{sy}$ is reduced by 36 Gauss and $f_F$ is increased by 0.1GHz and $f_F$ becomes 3.1GHz, as clearly understood from formula (35) $f_{L1}$ and $f_{L2}$ are also increased by 0.1GHz respectively and $f_{L1}$ becomes 2700MHz and $f_{L2}$ becomes 3042MHz, thereby receiving signal of $f_F-f_{L1} = 3100-2700 = 400(MHz)$ can be tuned and output of intermediate frequency $f_{1F} = f_F-f_{L2} = 3100-3042 = 58(MHz)$ is taken out from the second mixer 206 and any influence from the temperature does not exist.

In Fig. 33, magnetic fields applied to the filter circuit 205 and the second local oscillator 207 are fixed and magnetic field applied to the first local oscillator 204 is adjusted for the tuning. However, magnetic field to the first local oscillator 204 may be fixed and magnetic fields to the filter circuit 205 and the second local oscillator 207 may be adjusted in interlocking for the tuning. An example in such constitution will be described referring to Fig. 34. Parts in Fig. 34 corresponding to Fig. 33 are designated by the same reference numerals, and the repeated description shall be omitted. In the example, signal converted in frequency $f_{so1} = f_{so} + f_{L1}$ is taken out from a first mixer 203, and signal converted in frequency $f_{1F} = f_F + f_{L2}$ is taken out from a second mixer 206.

In this example, too, the temperature characteristics can be compensated by the circuit itself.

In any example of Fig. 33 and Fig. 34, specific structure of the filter circuit 205 and the first and second local oscillators 204 and 207 is similar to that of the filter circuit 2 and the local oscillator 5 in Fig. 1. Offset frequency in the filter circuit 205 and the second local oscillator 207 can be set in similar manner to the filter circuit 2 and the local oscillator 5 in Fig. 1 where prescribed d.c. bias magnetic field is applied in superposition to YIG element in one of the circuits.

In Fig. 33 and Fig. 34, a fixed magnetic field is applied to a part of the circuit and a variable magnetic field is applied to another part of the circuit. In this case, YIG element or circuit including this to supply the fixed magnetic field and other YIG element or circuit including this to supply the variable magnetic field are assembled in separate yokes 81, i.e. separate magnetic circuits, so as to generate required fixed magnetic field and variable magnetic field.

In a receiver of the invention as above described, constitution of magnetic resonance elements by machining such as YIG monocrystalline bulb or YIG monocrystalline plate is avoided, and YIG thin film elements are formed by thin film forming method such as liquid phase epitaxy, sputtering or chemical vapor deposit. Accordingly, mass production becomes easy, and characteristics between the filter circuit and the resonater in the local oscillator can be set accurately, thereby the tracking error can be effectively prevented without installing special circuit to correct the tracking error. Consequently, the invention is advantageous in that the constitution is simplified, the mass production becomes easy and the cost is reduced.

**Claims**

1. A signal converter comprising:
   - a filter (2; 205) formed of a first ferromagnetic resonator comprising a first ferrimagnetic crystal biased with a first D.C. bias magnetic field perpendicular to a major surface of said crystal supplied by a first D.C. bias mag-, netic filed means, said filter being supplied with an input signal to be converted, and deriving a filter signal having a first frequency;
   - a local oscillator (5; 207) formed of an active element and a second ferromagnetic resonator comprising a second ferrimagnetic crystal biased with a second D.C. bias magnetic field perpendicular to a major surface of said crystal supplied by a second D.C. bias magnetic field means, for deriving an oscillating signal having a second frequency; and
   - a mixer (4 - 206) for mixing said filter signal and said oscillating signal and for deriving a converted signal;
   **characterized in that**
   - said ferrimagnetic crystals are thin film crystals, wherein at least one of said thin films is processed to have different thicknesses in the central and peripheral regions to thereby suppress spurious response of ferromagnetic resonance caused by magnetostatic modes other than the uniform mode, and each of these crystals is magnetically coupled by a microstrip line (23, 24).

2. A signal converter according to claim 1, comprising
   - a second local oscillator (204) formed of an active element and a third ferromagnetic resonator comprising a third thin film ferrimagnetic crystal biased with a third D.C. bias magnetic field perpendicular to a major surface of said crystal supplied by a third D.C. bias magnetic field means, for deriving an oscillating signal having a third frequency; and
   - a second mixer (203) mixing an input signal and the output signal of said second local oscillator and supplying said mixed signal to said filter (205).

3. A signal converter according to one of the claims 1 or 2, wherein each of said ferrimagnetic crystals is a YIG thin film formed on a non-magnetic substrate by a liquid phase epitaxial growth technique.

4. A signal converter according to claims 1 or 2, wherein each of said ferrimagnetic crystal is YIG thin disk formed by liquid phase epitaxy having a groove at a peripheral portion of said disk.

5. A signal converter according to claims 1 or 2, wherein said ferrimagnetic crystal is YIG thin disk formed by liquid phase epitaxy having a thickness at a central portion of said disk smaller than a thickness at a peripheral portion of said disk.

6. A signal converter according to one of the claims 1 to 5, wherein said filtered signal and said oscillating signals have a certain frequency offset therebetween.

7. A signal converter according to claim 6, wherein said D.C. bias magnetic means are formed commonly for said ferrimagnetic crystals and said frequency offset is caused by different aspect ratios of said ferrimagnetic crystals.

8. A signal converter according to claim 6, wherein said ferrimagnetic crystals have the same aspect ratio and said frequency offset is caused by different magnetic fields.

9. A signal converter according to one of the claims 1 to 8, wherein said first and second D.C. bias magnetic fields are adjusted in interlocking the respective field applying means (6,7).

10. A signal converter according to one of the claims 1 to 9, wherein said ferrimagnetic crystals are formed on a common non magnetic substrate.

11. A signal converter according to one of the claims 1 to 10, wherein said ferrimagnetic crystals are placed in a common bias magnetic circuit.

12. A signal converter according to claim 2, wherein said first oscillating signal has a variable frequency in accordance with a variable D.C. bias magnetic field generated by said first D.C. bias magnetic field means, and said filtered signal and said second oscillating signal have fixed predetermined frequencies with a certain frequency offset between said filtered signal and said second oscillating signal.

13. A signal converter according to claim 2, wherein said first oscillating signal has a fixed frequency, and said filtered signal and said second oscillating signal are adjusted in interlocking, having a certain frequency offset between said filtered signal and said second oscillating signal.

**Patentansprüche**

1. Signalumsetzer mit:
   - einem Filter (2; 205), das auf einem ersten ferromagnetischen Resonator ausgebildet ist, der einen ersten ferrigmagnetischen Kristall aufweist, der mit einem ersten Gleich-Vormagnetisierfeld vormagnetisiert wird, das rechtwinklig zu einer Hauptfläche des Kristalles liegt und von einer ersten Einrichtung für ein Gleich-Vormagnetisierfeld geliefert wird, welchem Filter ein umzusetzendes Eingangssignal zugeführt wird, und das ein Filtersignal einer ersten Frequenz ausgibt;
   - einem Ortsoszillator (5; 207), der aus einem aktiven Element und einem zweiten ferromagnetischen Resonator gebildet ist, der einen zweiten ferrigmagnetischen Kristall aufweist, der mit einem zweiten Gleich-Vormagnetisierfeld vormagnetisiert wird, das rechtwinklig zu einer Hauptfläche des Kristalls steht und von einer zweiten Einrichtung für ein Gleich-Vormagnetisierfeld

17

EP 0 164 685 B1

geliefert wird, um ein Oszillatorsignal einer zweiten Frequenz auszugeben; und
- einem Mischer (4 - 206) zum Mischen des Filtersignals und des Oszillatorsignals und zum Erzeugen eines umgesetzten Signals;

**dadurch gekennzeichnet**, daß
- die ferrigmagnetischen Kristalle Dünnfilmkristalle sind, wobei mindestens einer der Dünnfilme so bearbeitet ist, daß er unterschiedliche Dicken in Mitten- und Randgebieten aufweist, um dadurch ein Falschansprechen ferromagnetischer Resonanz zu unterdrücken, wie es durch magnetostatische Moden neben der gleichförmigen Mode hervorgerufen wird, und daß jeder der Kristalle magnetisch durch einen Mikrostreifenleiter (23, 24) angekoppelt ist.

2. Signalumsetzer nach Anspruch 1, mit
- einem zweiten Ortsoszillator (204), der auf einem aktiven Element ausgebildet ist, und einem dritten ferromagnetischen Resonantor, der einen dritten Dünnfilm aus einem ferrigmagnetischen Kristall aufweist, der durch ein drittes Gleich-Vormagnetisierfeld vormagnetisiert wird, das rechtwinklig zu einer Hauptfläche des Kristalls steht und von einer dritten Einrichtung für ein Gleich-Vormagnetisierfeld geliefert wird, um ein Oszillatorsignal mit einer dritten Frequenz auszugeben; und
- einem zweiten Mischer (203), der ein Eingangssignal und das Aussgangssignal des zweiten Ortsoszillators mischt und das gemischte Signal an das Filter (205) liefert.

3. Signalumsetzer nach einem der Ansprüche 1 oder 2, bei dem jeder der ferrigmagnetischen Kristalle ein YIG-Dünnfilm ist, der auf einem unmagnetischen Substrat durch eine Flüssigphasenepitaxie-Wachstumstechnik ausgebildet ist.

4. Signalumsetzer nach einem der Ansprüche 1 oder 2, bei dem jeder der ferrigmagnetischen Kristalle eine dünne YIG-Scheibe ist, die durch Flüssigphasenepitaxie ausgebildet ist und eine Nut in einem Randbereich der Scheibe aufweist.

5. Signalumsetzer nach einem der Ansprüche 1 oder 2, bei dem der ferrigmagnetische Kristall eine dünne YIG-Scheibe ist, die durch Flüssigphasenepitaxie ausgebildet ist, und die in einem Mittenbereich der Scheibe eine Dicke aufweist, die kleiner ist als die Dicke im Randbereich der Scheibe.

6. Signalumsetzer nach einem der Ansprüche 1 bis 5, bei dem das gefilterte Signal und die Oszillatorsignale einen gewissen gegenseitigen Frequenzoffset aufweisen.

7. Signalumsetzer nach Anspruch 6, bei dem Einrichtungen für Gleich-Vormagnetisierung gemeinsam für die ferrigmagnetischen Kristalle ausgebildet sind und der Frequenzoffset durch verschiedene Längenverhältnisse der ferrigmagnetischen Kristalle bewirkt wird.

8. Signalumsetzer nach Anspruch 6, bei dem die ferrigmagnetischen Kristalle dieselben Längenverhältnisse aufweisen und der Frequenzoffset durch verschiedene Magnetfelder bewirkt wird.

9. Signalumsetzer nach einem der Ansprüche 1 bis 8, bei dem das erste und das zweite Gleich-Vormagnetisierfeld in wechselseitiger Kopplung durch die jeweiligen Einrichtungen (6, 7) zum Anlegen der Felder eingestellt werden.

10. Signalumsetzer nach einem der Ansprüche 1 bis 9, bei dem die ferrigmagnetischen Kristalle auf einem gemeinsamen unmagnetischen Substrat ausgebildet werden.

11. Signalumsetzer nach einem der Ansprüche 1 bis 10, bei dem die ferrigmagnetischen Kristalle in einem gemeinsamen Vormagnetisierkreis angeordnet sind.

12. Signalumsetzer nach Anspruch 2, bei dem das erste Oszillatorsignal eine variable Frequenz gemäß einem variablen Gleich-Vormagnetisierfeld aufweist, das von der ersten Einrichtung für das Gleich-Vormagnetisierfeld erzeugt wird, und das gefilterte Signal und das zweite Oszillatorsignal feste vorgegebene Frequenzen aufweisen, mit einem gewissen Frequenzoffset zwischen dem gefilterten Signal und dem zweiten Oszillatorsignal.

18

**13.** Signalumsetzer nach Anspruch 2, bei dem das erste Oszillatorsignal eine feste Frequenz aufweist und das gefilterte Signal und das zweite Oszillatorsignal in wechselseitiger Kopplung eingestellt werden, mit einem gewissen Frequenzoffset zwischen dem gefilterten Signal und dem zweiten Oszillatorsignal.

**Revendications**

**1.** Convertisseur de signaux, comprenant
- un filtre (2 ; 205) formé d'un premier résonateur ferromagnétique comprenant un premier cristal ferrimagnétique polarisé par un premier champ magnétique continu de polarisation qui est perpendiculaire à une grande face du cristal et qui est appliqué par un premier dispositif d'application d'un champ magnétique continu de polarisation, le filtre recevant un signal d'entrée à transformer et dérivant un signal de filtre ayant une première fréquence,
- un oscillateur local (5 ; 207) formé d'un élément actif et d'un second résonateur ferromagnétique comprenant un second cristal ferrimagnétique polarisé par un second champ magnétique continu de polarisation qui est perpendiculaire à une grande face du cristal et qui est appliqué par un second dispositif d'application d'un champ magnétique continu de polarisation, afin qu'un signal oscillant soit dérivé à une seconde fréquence, et
- un mélangeur (4-206) destiné à mélanger le signal du filtre et le signal d'oscillation et à dériver un signal transformé,
  caractérisé en ce que
- les cristaux ferrimagnétiques sont des cristaux en couche mince, l'une au moins des couches minces est traitée afin qu'elle possède des épaisseurs différentes dans des régions centrale et périphérique afin que la réponse parasite de la résonance ferromagnétique provoquée par des modes magnétostatiques autres que le mode uniforme soit supprimée, chacun des cristaux étant couplé magnétiquement par une microligne plate (23, 24).

**2.** Convertisseur de signaux selon la revendication 1, comprenant
- un second oscillateur local (204) formé d'un élément actif et un troisième résonateur ferromagnétique comprenant un troisième cristal ferrimagnétique à couche mince polarisé par un troisième champ magnétique continu de polarisation qui est perpendiculaire à une grande face du cristal et qui est appliqué par un troisième dispositif d'application d'un champ magnétique continu de polarisation, afin qu'un signal oscillant ayant une troisième fréquence soit dérivé, et
- un second mélangeur (203) qui mélange un signal d'entrée au signal de sortie du second oscillateur local et qui transmet le signal mélangé au filtre (205).

**3.** Convertisseur de signaux selon l'une des revendications 1 et 2, dans lequel chacun des cristaux ferrimagnétiques est une couche mince de YIG formée sur un substrat non magnétique par une technique de croissance par épitaxie en phase liquide.

**4.** Convertisseur de signaux selon la revendication 1 ou 2, dans lequel chacun des cristaux ferrimagnétiques est un disque mince de YIG formé par épitaxie en phase liquide, ayant une gorge à une partie périphérique du disque.

**5.** Convertisseur de signaux selon la revendication 1 ou 2, dans lequel le cristal ferrimagnétique est un disque mince de YIG formé par épitaxie en phase liquide ayant une épaisseur, dans la partie centrale du disque, qui est inférieure à l'épaisseur dans une partie périphérique du disque.

**6.** Convertisseur de signaux selon l'une des revendications 1 à 5, dans lequel le signal filtré et des signaux oscillants présentent un certain décalage mutuel de fréquence.

**7.** Convertisseur de signaux selon la revendication 6, dans lequel les dispositifs d'application d'un champ magnétique continu de polarisation sont formés en commun pour les cristaux ferrimagnétiques et le décalage de fréquence est dû à différents rapports d'allongement des cristaux ferrimagnétiques.

**8.** Convertisseur de signaux selon la revendication 6, dans lequel les cristaux ferrimagnétiques ont le même rapport d'allongement et le décalage de fréquence est provoqué par des champs magnétiques différents.

**9.** Convertisseur de signaux selon l'une des revendications 1 à 8, dans lequel le premier et le second champ magnétique continu de polarisation sont ajustés par action solidarisée des dispositifs respectifs d'application de champ (6, 7).

**10.** Convertisseur de signaux selon l'une des revendications 1 à 9, dans lequel les cristaux ferrimagnétiques sont formés sur un substrat non magnétique commun.

**11.** Convertisseur de signaux selon l'une des revendications 1 à 10, dans lequel les cristaux ferrimagnétiques sont placés sur un circuit magnétique commun de polarisation.

**12.** Convertisseur de signaux selon la revendication 2, dans lequel le premier signal oscillant a une fréquence variant en fonction d'un champ magnétique continu variable de polarisation créé par le premier dispositif d'application d'un champ magnétique continu de polarisation, et le signal filtré et le second signal oscillant ont des fréquences fixes prédéterminées présentant un certain décalage de fréquence entre le signal filtré et le second signal oscillant.

**13.** Convertisseur de signaux selon la revendication 2, dans lequel le premier signal oscillant a une fréquence fixe, et le signal filtré et le second signal oscillant sont ajustés par action solidarisée et présentent un certain décalage de fréquence entre le signal filtré et le second signal oscillant.

FIG. 1

FIG. 2

FIG. 4

FIG. 3

FIG. 5

## FIG. 6a

## FIG. 6b

## FIG. 7

## FIG. 8

# FIG. 9

# FIG. 10

EP 0 164 685 B1

# FIG.11

# FIG.12

# FIG.13

# FIG. 14

4450                                                4940

# FIG. 15

# FIG. 16

# FIG. 18

# FIG. 17

70
27(28,55)
29(56,93)

# FIG. 19

# FIG. 20

# F I G. 21

# F I G. 22

## FIG. 23

71
27(28,55)
29(56,93)

## FIG. 24

(GHz)

(dB)

# FIG. 25

# FIG. 26

# FIG. 27

# FIG. 28

# FIG. 29

$\ell_{x2}$ (mm) ⟶

# FIG. 30

# FIG. 31

$4\pi M_{soy}$

$4\pi M_{sy}(T)$

Ti    To    T2    T

# FIG. 32

2.7G

$4\pi M_s(T)$

$4\pi M_{so}\{1+a(T-T_0)\}$
$=1771.8\{1-0.00207(T-20)\}$

3G

-20°C    20°C    60°C    T

# FIG. 33

# FIG. 34